# EUROPEAN PATENT APPLICATION

(11) **EP 0 910 116 A2**
(43) Date of publication of application: **21.04.1999**
(21) Application number: 98119552.2
(22) Date of filing: 16.10.1998
(51) Int. Cl.: H01L 21/306

(54) **Cleaning a potassium contaminated surface with pure hot water**

(30) Priority: 17.10.1997 JP 285796/97
(71) Applicant: CANON KABUSHIKI KAISHA, Tokyo (JP)
(72) Inventor: Tadahiro, Ohmi, Sendai-shi, Miyagi-ken (JP); Matsuomi, Nishimura, c/o Canon Kabushiki Kaisha, Tokyo (JP); Takayuki, Jizaimaru, Yamato-shi, Kanagawa-ken (JP)
(74) Representative: Pellmann, Hans-Bernd, Dipl.-Ing.

(57) **Abstract**

A treating method can effectively and efficiently remove alkali metals including potassium. It cleans an object brought into contact with a potassium-containing treatment agent by holding the object in contact with pure water heated to or above 80°C.

## Description

### BACKGROUND OF THE INVENTION

### Field of the Invention

This invention relates to a method of cleaning an object to be suitably used in the process of manufacturing semiconductor devices such as DRAMs and other semiconductor memories and microprocessors, in the process of manufacturing electrooptic devices such as liquid crystal display devices and plasma display devices and in the process of manufacturing optical devices such as lenses, mirrors and optical filters.

### Related Background Art

Firstly, typical known cleaning methods of the category under consideration will be discussed in terms of a process of manufacturing semiconductor devices. They include one referred to as RCA cleaning and one using pure water for washing off chemical solutions as described in Japanese Patent Application Laid-Open No. 1-19740 after developing or etching photoresist or stripping off a photoresist layer.

The RCA cleaning process comprises a total of twelve steps including a cleaning step using a mixture solution of sulfuric acid and hydrogen peroxide heated to 120°C to 150°C. It involves the use of ammonia, hydrochloric acid and other chemicals at an enhanced rate in addition to sulfuric acid and hence a large volume of ultrapure water has to be consumed to wash them off.

Additionally, vapor of chemicals heated normally to temperature above 100°C in the process can damage the components of the air conditioning system of the clean room used for the process and ammonium sulfide, which is a byproduct of the process, can give rise to particles in the clean room and rust the apparatus for manufacturing semiconductor devices. Still additionally, if chemical amplification type photoresist is used during the process of manufacturing semiconductor devices, the atmosphere in which the photoresist is handled should be completely isolated from vapor of ammonia.

A cleaning method has been proposed to solve the above identified problems ("Nikkei Microdevice", March, 1997, pp. 90-95, "Keisoku to Seigyo (Measurement and Control)", No. 3, Vol. 35, March, 1996, pp. 171-178). The proposed method comprises a first step of using ultrapure water containing ozone (O₃) by 5ppm, a second step of carrying out a cleaning operation by using a cleansing solution containing hydrofluoric acid (HF) by 0.5%, hydrogen peroxide (H₂O₂) by 0.1 to 1.0% and a surface active agent by 50ppm and applying ultrasonic waves, a third step of carrying out a cleaning operation by using ultrapure water containing ozone by 1ppm, a fourth step of carrying out a cleaning operation by using 0.1% dilute hydrofluoric acid and a fifth step of carrying out a cleaning operation by using ultrapure water and applying ultrasonic waves, which steps are conducted in the above mentioned order.

The above cleaning method can also be adopted for the process of manufacturing electrooptic devices.

On the other hand, known methods of cleaning optical devices such as lenses are relatively simple and mostly consist in cleaning with water at room temperature or wiping the object with a piece of unwoven fabric impregnated with organic solvent such as alcohol.

However, it has been found that some of the substances that adhere to semiconductor devices during the manufacturing process cannot be removed by any of the above described methods.

For example, the technique of chemical mechanical polishing (CMP) has been recently used in the process of manufacturing semiconductor devices for planarizing the insulation film on the surface of the substrate in order to produce multilayered wires having a width less than 0.25µm. With the CMP technique, a polishing solution obtained by dispersing particles of silicon oxide, etc. into a potassium-containing treatment solution such as aqueous solution of potassium hydroxide (KOH). It has been found that, once potassium contained in the polishing solution adheres to the interlayer insulation layer to be polished, it cannot be removed even by any novel polishing technique.

A mixture solution of sulfuric acid and hydrogen peroxide heated to temperature between 130°C and 150°C is typically used to remove photoresist after the exposure and etching step of the known wet treatment process. The inventors of the present invention tried a novel method of removing resist by applying ultrasonic waves to the resist stripping solution containing organic solvent such as isopropyl alcohol (IPA) and halogenated alkali such as KF in order to strip off the photoresist layer without using heated chemical agents. However, it was also found that potassium contained in the resist stripping solution can be adsorbed by the interlayer insulation layer.

As for optical devices, a remarkable problem appears in excimer laser steppers using KrF or ArF and aligners using the i line, although cameras and telescopes are exempt from the problem. It is the shading in the intensity of illumination due to foreign objects adhered to the lens having an antireflection coating or the mirror equipped with a reflective coating. No reliable method has been found to remove such foreign objects.

### SUMMARY OF THE INVENTION

In view of the above identified problems, it is therefore an object of the present invention to provide a cleaning method that can effectively and efficiently remove alkali metals including potassium and significantly reduce the amount of alkali metals adhering to an object.

Another object of the invention is to provide a simple cleaning method that can effectively and efficiently remove alkali metals including potassium without using chemical solutions containing sulfuric acid or hydrochloric acid to a high concentration.

According to an aspect of the invention, the above objects are achieved by providing a method of cleaning an object having a layer brought into contact with a potassium-containing treatment agent and a surface treatment method to be used for the object, characterized in that:
the layer of the object is held in contact with pure water heated to or above 80°C.

According to another aspect of the invention, there is provided a method of cleaning an object having a layer on the surface, the layer being formed by a plasma processing method, a chemical vapor phase deposition method and/or a physical vapor phase deposition method and brought into contact with a potassium-containing treatment agent, characterized in that:
the object is held in contact with pure water heated to or above 80°C.

According to still another aspect of the invention, there is provided a method of cleaning an object having a layer on the surface, the layer being formed of a nonstoichiometric compound and brought into contact with a potassium-containing treatment agent, characterized in that:
the object is held in contact with pure water heated to or above 80°C.

According to still another aspect of the invention, there is provided a method of cleaning an object comprising a first cleaning step of using ultrapure water containing ozone, a second cleaning step of conducting a cleaning operation by using a liquid containing hydrofluoric acid, hydrogen peroxide and a surface active agent and applying ultrasonic waves with a frequency above 100kHz, a third cleaning step of conducting a cleaning operation by using ultrapure water containing ozone and applying ultrasonic waves with a frequency above 100kHz, a fourth cleaning step of conducting a cleaning operation by using a liquid containing hydrofluoric acid and a fifth cleaning step of conducting a cleaning operation by using ultrapure water and applying ultrasonic waves with a frequency above 100kHz, characterized by:
further comprising a sixth cleaning step of bringing the object into contact with pure water heated to or above 80°C.

According to a further aspect of the invention, there is provided a method of cleaning an object comprising a step of removing organic substances adhering to the object by using a liquid containing organic solvent and halogenated potassium and applying ultrasonic waves, characterized by:
further comprising a step of bringing the object into contact with pure water heated to or above 80°C after the removing step.

According to a further aspect of the invention, there is provided a method of cleaning an object polished by means of a potassium-containing treatment agent, characterized by:
comprising a step of bringing the object into contact with pure water heated to or above 80°C.

According to a further aspect of the invention, there is provided a method of treating an object having a layer on the surface, the layer being formed of a nonstoichiometric compound, characterized by comprising:
a first step of bringing the film of the object into contact with a potassium-containing treatment agent; and
a second step of reducing the amount of potassium adhering to the film by bringing the film of the object into contact with pure water heated to or above 80°C after the first step.

### BRIEF DESCRIPTION OF THE DRAWINGS

FIG. 1 is a schematic illustration of a cleaning apparatus that can be used with a cleaning method according to the invention.
FIG. 2 is a graph showing the relationship between the time of dipping into a potassium-containing solution and the extent of potassium adhesion.
FIG. 3 is a graph showing the relationship between the KOH concentration of a potassium-containing solution and the extent of potassium adhesion.
FIG. 4 is a graph showing the relationship between the pH of a potassium-containing solution and the extent of potassium adhesion and the oxidation-reduction potential of the solution.
FIG. 5 is a chart showing the change with time of the extent of potassium adhesion on various specimens.
FIG. 6 is a chart illustrating ion exchange reactions.
FIG. 7 is a graph showing the cleaning effect on adhering potassium of various cleaning solutions.
FIG. 8 is a graph showing the cleaning effect on adhering potassium of various cleaning solutions selected for comparison.
FIG. 9 is a graph showing the cleaning effect on adhering potassium of various cleaning solutions selected also for comparison.
FIG. 10 is a graph showing the cleaning effect on adhering potassium and the etching thickness of an HF cleaning solution.
FIG. 11 is a graph showing the cleaning effect on adhering potassium of the temperature of pure water used for cleaning.
FIG. 12 is a schematic illustration of another cleaning apparatus that can be used with a cleaning method according to the invention.
FIGS. 13A, 13B, 13C, 13D and 13E are schematic cross sectional views of a semiconductor device in different manufacturing steps of an example as will be described hereinafter.
FIGS. 14A, 14B, 14C, 14D and 14E illustrate different cleaning steps of a cleaning method according to the invention used in the process of manufacturing a semiconductor device of an example as will be described hereinafter.

### DESCRIPTION OF THE PREFERRED EMBODIMENTS

In a preferable mode of carrying out the invention, the object of treatment carrying potassium adhering thereto is held in contact with pure water heated to or above 80°C to remove the adhering potassium. In this mode of carrying out the invention, adhering potassium can be removed to a reduced amount in a simple fashion without using a solution containing chemicals at high concentration.

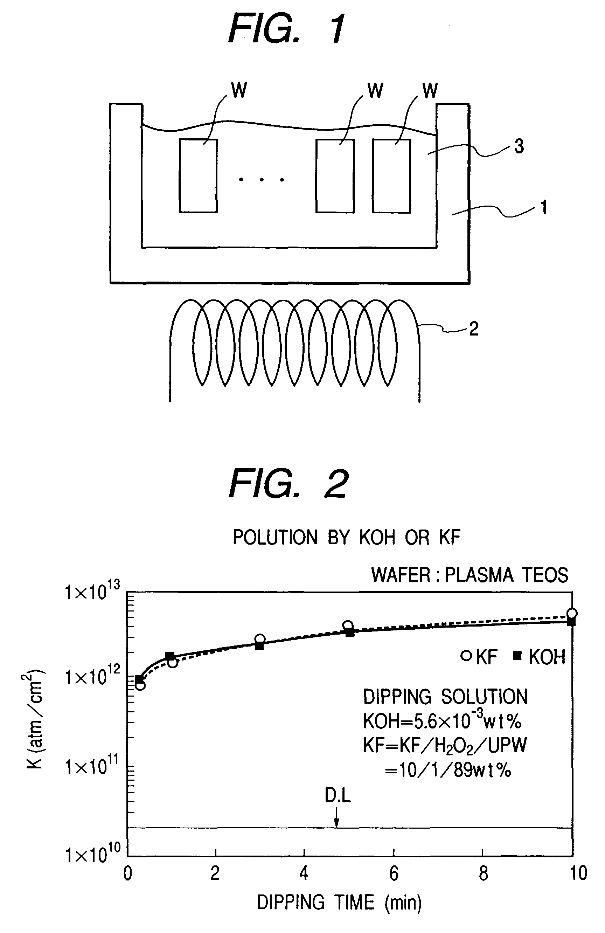

FIG. 1 is a schematic illustration of a cleaning apparatus that can suitably be used with a cleaning method according to the invention.

Referring to FIG. 1, there are shown a cleaning liquid tank 1 for storing cleaning liquid provided with an external heater 2 for heating the cleaning liquid in the tank 1 to predetermined temperature. The cleaning chamber inside the liquid tank contains pure water 3, which is heated and held to a temperature range between 80°C and 100°C by means of the heater 2.

At least an object W that has been treated with a potassium-containing treatment agent is dipped into the hot water 3 in the liquid tank 1 for several seconds to several hours to remove potassium. Alternatively, pure hot water may be fed to the object through a nozzle to clean the object.

### (Surface Treatment of an Object Using a Potassium-Containing Treatment Agent)

FIG. 2 is a graph showing the relationship between the time of dipping into a potassium-containing solution and the extent of potassium adhesion. In an experiment conducted for the purpose of this invention, two specimens of silicon wafer were coated with non-doped silicon oxide film by means of plasma CVD using tetraethoxysilane (TEOS), an organic silicon compound. On the other hand, an aqueous solution containing KOH by 5.6×10⁻³wt% and another aqueous solution containing KF, H₂O₂ and pure water to a ratio by weight of 10:1:89 were prepared. FIG. 2 shows the results obtained by dipping the two specimens into the respective aqueous solutions and observing the extent of potassium adhesion over a certain period of time.

It will be seen that, the instant the specimens were dipped into the respective aqueous solutions, potassium was adsorbed by the specimens at a rate of 1×10¹²atm/cm² and the extent of adsorption increased gradually until a saturation level between 10¹² and 10¹³atm/cm² was reached.

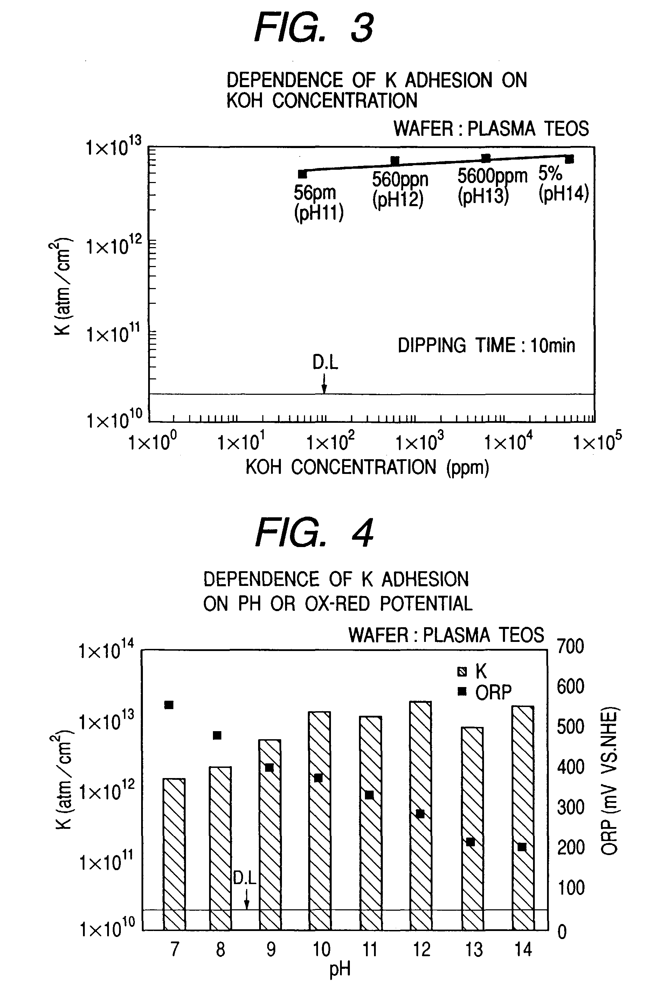

FIG. 3 is a graph showing the relationship between the KOH concentration of a potassium-containing solution and the extent of potassium adhesion. Specimens of silicon wafers coated with silicon oxide film same as the above described ones were prepared. On the other hand, aqueous solutions containing KOH by 56ppm, 560ppm, 5600ppm and 5% were prepared. They showed a pH value between 11 and 14. Then, the specimens were dipped into the respective aqueous solutions for 10 minutes and the extent of potassium adhesion was observed on each of the specimens.

In the graph of FIG. 3, the horizontal axis represents the KOH concentration of the aqueous solutions into which the specimens were dipped and the vertical axis represents the extent of potassium adhesion of the specimens. It will be seen that the extent of potassium adhesion remained somewhere around 1×10¹²atm/cm² to show no remarkable change if the KOH concentration changed by three digits, or 10³, or if the pH value increased from 11 to 14.

FIG. 4 is a graph showing the relationship between the pH of a potassium-containing solution and the extent of potassium adhesion and the oxidation-reduction potential of the solution. Specimens of silicon wafers coated with non-doped silicon oxide film same as the above described ones were prepared. On the other hand, various aqueous solutions containing KOH and KCl to different concentrations were prepared. They showed a pH value between 7 and 14. Then, the specimens were dipped into the respective aqueous solutions for 10 minutes and the extent of potassium adhesion was observed on each of the specimens.

In the graph of FIG. 4, the horizontal axis represents the pH of the aqueous solution, whereas the vertical axes on the left and right sides represent respectively the extent of potassium adhesion and the oxidation-reduction potential (ORP) of the solution. The oxidation-reduction potential was correlated with the pH and decreased from about 600mV to about 200mV as the pH changed from 7 to 14. On the other hand, the extent of potassium adhesion changed only slightly from about 10¹² to about 10¹³atm/cm² if the pH value was raised from 7 to 14 to represent a remarkable shift from a neutral or slightly alkaline condition to a strongly alkaline condition. The extent of potassium adhesion was rather stable when the pH value was 10 or above. The extent of potassium adhesion did not show any significant dependency on the oxidation-reduction potential of the solution.

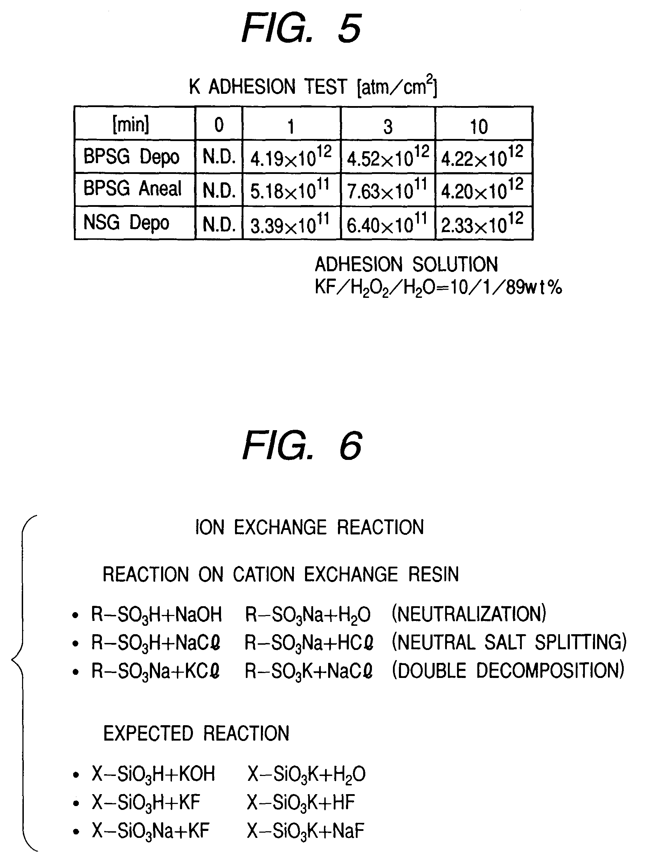

FIG. 5 is a chart showing the change with time of the extent of potassium adhesion on various specimens. More specifically, some of the specimens were prepared by forming boron/phosphor-doped silicon oxide (BPSG) film on silicon wafers by deposition (BPSG as Depo) in an atmospheric pressure CVD system using TEOS, trimethyl borate, trimethyl phosphate and ozone. Some of them were annealed at 200°C (BPSG as Anneal) after the deposition of BPSG film. The remaining specimens were prepared by forming non-doped silicon oxide (NSG) film on silicon wafers by deposition (NSG as Depo) in an atmospheric pressure CVD system using TEOS and ozone. The specimens of three different types were then immersed in a potassium-containing aqueous solution containing KF, H₂O₂ and water to a ratio by weight of 10:1:89 and the extent of potassium adhesion was observed on each of the specimens regularly after the start of immersion. As seen from FIG. 5, while potassium adhesion of all the specimens was less than the detectable limit before dipping into a potassium-containing aqueous solution, the extent of potassium adhesion rose to above 10¹¹atm/cm² after having been dipped into it.

Then, two types of specimens were prepared, bare silicon wafers and silicon wafers having the surface thermally oxidized, and dipped into a potassium-containing aqueous solution for ten minutes to find that both of them did not show any potassium adhesion after the dipping. Thus, it can be safely concluded that remarkable potassium adhesion is observable with a compound having a composition that does not satisfy the stoichiometric atomic ratio. It seems that the problem of potassium adhesion and potassium pollution has not hitherto been realized because the cleaning effect of any known cleaning method has been evaluated by using bare wafers or thermally oxidized wafers.

As a result of the experiments described above by referring to FIGS. 2 through 5, it was found that once an object is brought into contact with a potassium-containing liquid for even a second, potassium instantaneously adheres to it to an extent of more than 10¹¹atm/cm² regardless if the liquid is weakly alkaline or strongly alkaline and regardless of the oxidation-reduction potential of the liquid.

Now, let us look into potassium adhesion and the chemical reaction that takes place as a result of potassium adhesion. Take, for example, the reaction of cation exchange resin. It essentially consists in three principal reactions of neutralization, neutral salt splitting and double decomposition as shown in FIG. 6. Assume now that silicon oxide does not satisfy the stoichiometric atomic ratio. Then, potassium will adhere to nonstoichiometric silicon oxide by way of the three reactions shown in FIG. 6.

The process of manufacturing semiconductor devices, to which the present invention is applicable, includes surface treatment steps using a potassium-containing treatment agent such as a chemical-mechanical polishing (CMP) using a polishing solution containing KOH, a photoresist stripping step using KF and an etching step using KOH. Additionally, KOH and KF are sometimes used for cleaning electrooptic devices and optical devices. Thus, it is desirable to conduct a potassium cleaning operation as will be described hereinafter after such a surface treatment step using a potassium-containing solution.

Potassium-containing solutions that are used in the process of manufacturing semiconductor devices include aqueous and non-aqueous solutions containing KOH, KF, KCl and/or K₂SO₄. Specific examples of solvents that can be used for such solutions include organic solvents such as IPA (isopropyl alcohol), toluene, acetone, methyl alcohol and ethyl alcohol, those diluted with water and water.

### (Potassium Removal by Cleaning with Hot Water)

Now, a technique of removing the potassium adhering to an object will be described.

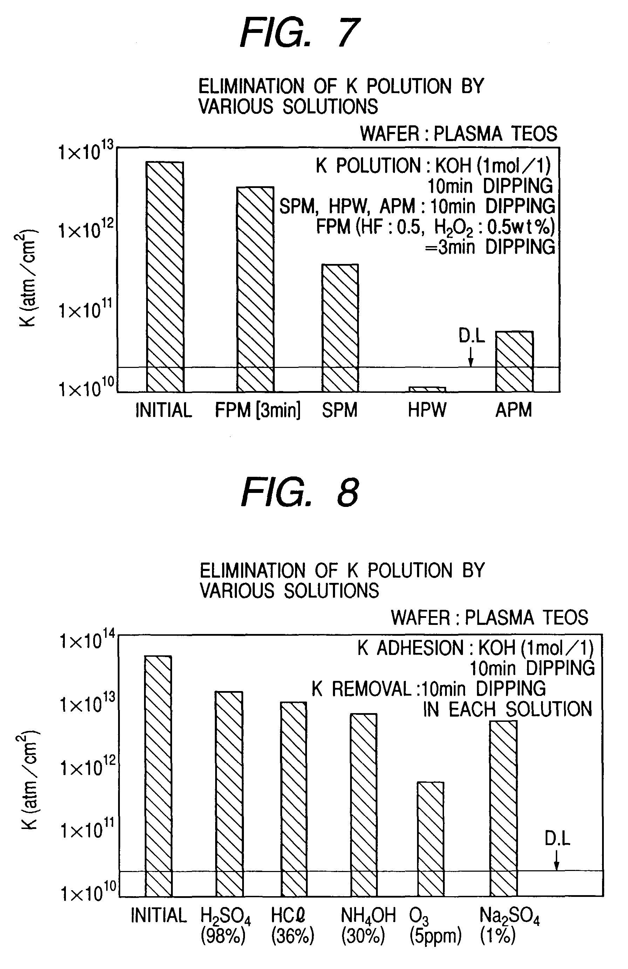

FIG. 7 is a graph showing the cleaning effect on adhering potassium of various cleaning solutions. In an experiment, four different cleaning solutions were prepared; an 80°C aqueous solution containing HF by 0.5wt% and hydrogen peroxide by 0.5wt% (FPM), an 80°C aqueous solution containing sulfuric acid (SPM), 80°C ultrapure water (HPW) and an 80°C aqueous solution containing ammonia and hydrogen peroxide (APM). On the other hand, specimens of silicon wafers carrying silicon oxide film prepared by plasma CVD were previously dipped into a 1.0mol/l KOH aqueous solution for 10 minutes. The specimens were observed for the extent of potassium adhesion before cleaning and then dipped into the respective cleaning solutions for 10 minutes (3 minutes only for the FPM). FIG. 7 is a graph showing the cleaning effect on adhering potassium of each of the cleaning solutions. It will be seen that only the HPW could remove potassium to an extent below the detectable limit.

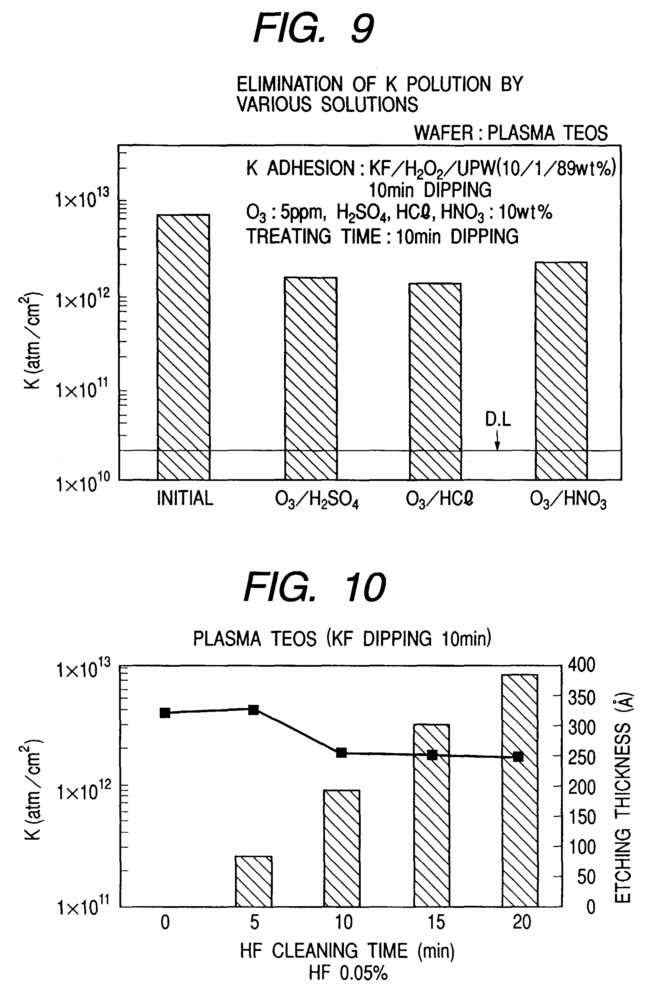

FIG. 8 is a graph showing the cleaning effect on adhering potassium of different cleaning solutions selected for the purpose of comparison. As in the case of the above described experiment, specimens of silicon wafers carrying silicon oxide film were prepared by plasma CVD. The solutions were sulfuric acid, hydrochloric acid, aqueous ammonia, ozone-containing water and an aqueous solution of sodium sulfide. All the solutions were held to room temperature. As seen from FIG. 8, any of the cleaning solutions could not satisfactorily remove potassium. FIG. 9 is a graph showing the cleaning effect on adhering potassium of still other different cleaning solutions selected also for the purpose of comparison. As in the case of the above described experiment, specimens of silicon wafers carrying silicon oxide film were prepared by plasma CVD and then dipped into a liquid containing KF, H₂O₂ and ultrapure water (UPW) to a ratio by weight of 10:1:89. The cleaning solutions were an aqueous solution containing sulfuric acid by 10wt% and ozone by 5ppm, an aqueous solution containing hydrochloric acid by 10wt% and ozone by 5ppm and an aqueous solution containing nitric acid by 10wt% and ozone by 5ppm. They were held to room temperature. As seen from FIG. 9, any of the cleaning solutions could not satisfactorily remove potassium.

FIG. 10 is a graph showing the cleaning effect on adhering potassium and the etching thickness of an HF cleaning solution obtained in an experiment where specimens of silicon wafers carrying silicon oxide film prepared by plasma CVD which were previously dipped into a potassium-containing solution for potassium adhesion were dipped into a 0.05% HF aqueous solution for 10 minutes for cleaning. As the duration of dipping into the HF solution increased, the etching thickness was also increased until the potassium-carrying silicon oxide film was almost etched out but the extent of potassium adhesion did not show any significant reduction throughout the experiment. This indicates that the potassium adhering to a silicon wafer cannot be removed by means of any etching technique that may be defined as a cleaning technique in a broad sense of the words.

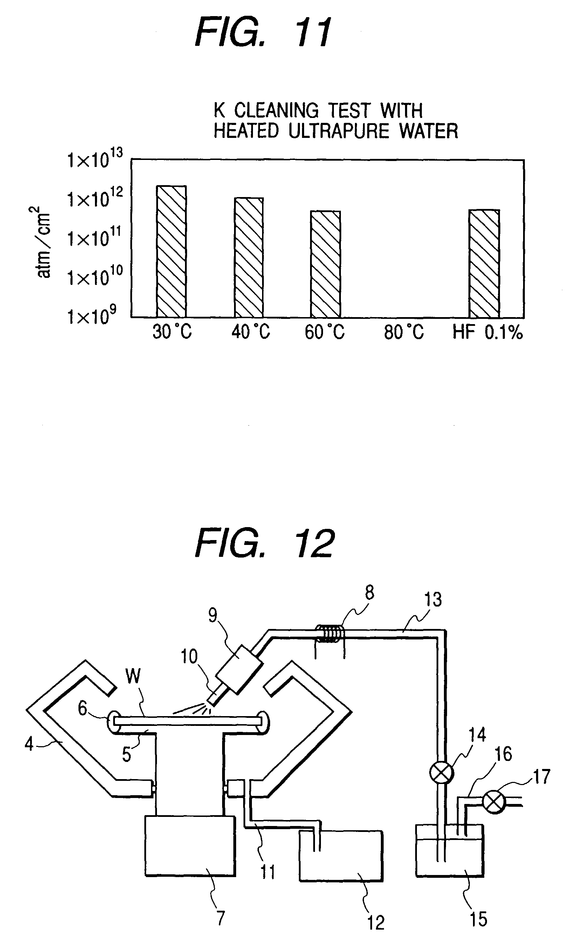

FIG. 11 is a graph showing the cleaning effect on adhering potassium of the temperature of pure water used for cleaning. Specimens of silicon wafers carrying a BPSG film that had not been annealed after the deposition were dipped into a 1.0mol/liter KOH aqueous solution for 10 minutes. Meanwhile, five different cleaning liquids were prepared. They included ultrapure water contained in four different vessels, which were heated to 30°C, 40°C, 60°C and 80°C respectively, and a 0.1% HF aqueous solution. After dipping the specimens into the five different cleaning liquids, it was found that the extent of potassium adhesion fell to below 10⁹atm/cm² only in the ultrapure water heated to 80°C.

On the basis of the experiments described above by referring to FIGS. 7 through 11, it can safely be concluded that the use of pure water heated to above 80°C is desirable for removing the potassium adhering to an object. For the purpose of the invention, the object is either dipped (by means of an apparatus as shown in FIG. 1) into, or sprayed with, hot pure water heated to temperature between 80°C and 99°C, preferably between 80°C and 90°C, so that the object may be held in direct contact with water.

Additionally, an ultrasonic wave with a frequency between 0.8MHz and 10MHz may be applied to the object that is held in contact with hot pure water.

### (Objects)

Objects apt to be adhered by potassium includes compound insulators formed by deposition by means of thermal CVD or plasma CVD at temperature below 800°C and, if necessary, heat treated between 100°C and 450°C and those formed by deposition by means of sputtering and, if necessary, heat treated. Oxide insulators formed by a plasma treatment of exposing the substrate surface to oxygen plasma and, if necessary, heat treated are also apt to be adhered by potassium. Specific insulators include non-single-crystalline compounds such as silicon oxide, silicon nitride, aluminum oxide and tantalum oxide, which may be, if necessary, doped with boron or phosphor. The compound layer formed by any of the above deposition techniques mostly contains a non-single-crystalline compound having an atomic ratio that is not compatible with the stoichiometric atomic ratio.

Substrates to be suitably used for forming any of the above compound insulators include single-crystalline semiconductor wafers such as Si, Ge, GaAs and InP wafers, quartz substrates and glass substrates.

Objects (of works, articls, etc.) that can be cleaned by a method according to the invention include ceramic objects.

A cleaning method according to the invention shows a remarkable cleaning effect when used for cleaning objects carrying any of the above listed films.

FIG. 12 is a schematic illustration of another cleaning apparatus that can be used with a cleaning method according to the invention.

Referring to FIG. 12, object W of cleaning (a disk-shaped silicon wafer) is rigidly secured by claws 6 on a holder 5 arranged in cleaning tank 4 having warped side walls designed to prevent the cleaning solution from scattering away. The object W revolves with the holder 5 as the latter is driven by a drive unit, which is a rotary motor 7. The cleaning solution, which is ultrapure water, is heated to temperature between 80°C and 100°C by means of a heater 8 and ultrasonic waves having a frequency greater than 100kHz, preferably between 0.8MHz and 10MHz, are applied to the ultrapure water by an ultrasonic wave vibrator 9. Hot ultrapure water to which ultrasonic waves are applied is then sprayed aslant onto the revolving object from a nozzle 10. Used water is then collected in a waste liquid tank 12 by way of a drain pipe 11. The ultrapure water supply system includes a gas supply pipe 16 and a valve 17 for applying gas pressure to pure water in addition to a water supply pipe 13, a valve 14 and a pure water container 15. With this arrangement, the rate of consumption of cleaning liquid per object is held low so that the running cost can be minimized if waste liquid is recycled. Alternatively, hot pure water may be supplied to fall drop by drop or simply flow out from the nozzle 10.

### (Example 1)

A single-crystalline silicon wafer was selected as object of cleaning and a compound film which was silicon oxide film having a nonstoichiometric atomic ratio was formed on the surface thereof by means of plasma CVD using TEOS. The wafer carrying the silicon oxide film was mounted on a chemical-mechanical polishing apparatus and the silicon oxide film was polished to reduce its thickness by means of a polishing liquid of aqueous solution containing KOH and dispersed silica fine particles as an abrasive and a polyurethane polishing pad. (treatment step using a potassium-containing solution). After washing the wafer with ultrapure water at room temperature, the extent of potassium adhesion of the wafer was observed to find it to be 8×10¹²atm/cm².

The silicon wafer carrying the silicon oxide film still adhered by potassium after the polishing operation was then immersed in ultrapure water held to 80°C in a thermostat tank for 10 minutes.

Subsequently, the wafer was taken out of the thermostat tank and the extent of potassium adhesion was observed to find that it had been reduced to below the detectable limit. In other words, no significant adhesion of potassium to the silicon oxide film on the surface of the wafer was observed.

### (Example 2)

A silicon wafer was selected as object of cleaning and a compound film which was silicon oxide film having a nonstoichiometric atomic ratio was formed on the surface thereof by means of plasma CVD using tetraethoxysilane (TEOS).

The wafer was then pre-baked at 150°C and hexamethyldisilazane (HMDS) was applied to the surface. Then, photoresist was applied to the surface to form a layer having a thickness between 1.0 and 1.3µm. Thereafter, the object was baked at 90°C and rinsed with ultrapure water at room temperature before it was subjected to a post-baking process at 130°C.

The specimen of wafer carrying a silicon oxide film and coated with photoresist was then dipped into a resist stripping solution, which was an aqueous solution containing KF by 1.9wt% and IPA by 54wt%, and ultrasonic waves of 0.95MHz were applied to the solution. Thus, the resist on the wafer was removed by dipping the specimen into the resist stripper for 1 to 2 minutes. The wafer stripped of resist was then washed with ozone-containing ultrapure water at room temperature and then rinsed with ultrapure water also at room temperature. After the rinse, the extent of potassium adhesion of the wafer was observed to find it to be 8×10¹²atm/cm².

The silicon wafer carrying the silicon oxide film still adhered by potassium after the polishing operation was then immersed in ultrapure water held to 80°C in a thermostat tank for 2 minutes. Subsequently, the wafer was taken out of the thermostat tank and the extent of potassium adhesion was observed to find that it had been reduced to below the detectable limit. In other words, no significant adhesion of potassium to the silicon oxide film on the surface of the wafer was observed.

### (Example 3)

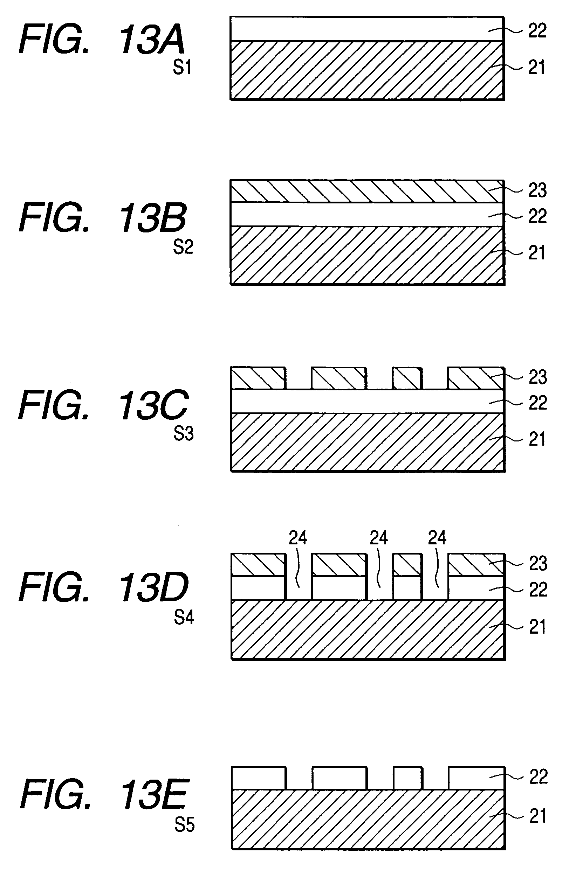

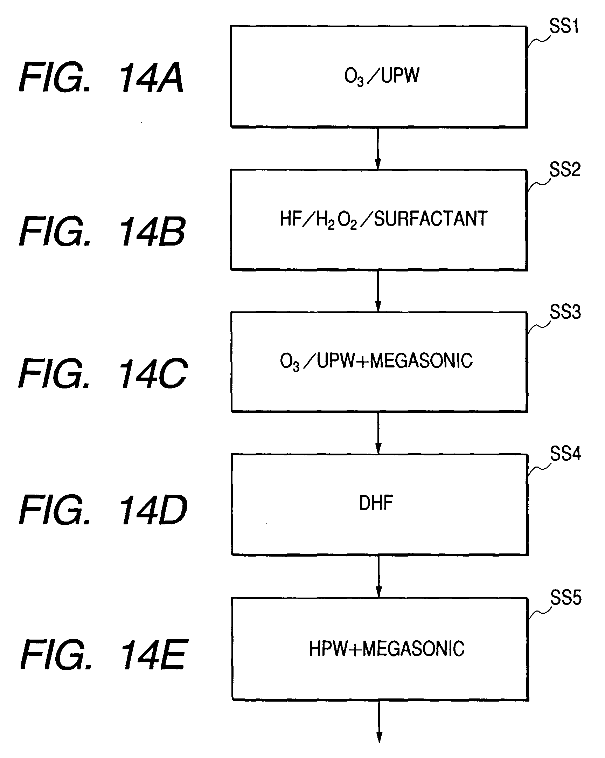

The cleaning method used in this example for a process of manufacturing semiconductor devices will be described by referring to FIGS. 13A through 13E and 14A through 14E.

A silicon wafer 21 was selected as object of cleaning and a compound film 22 which was silicon oxide film having a nonstoichiometric atomic ratio was formed on the surface thereof to a thickness of about 1µm by means of plasma CVD using tetraethoxysilane (TEOS) (Step S1, FIG. 13A).

The wafer was then pre-baked at 150°C and hexamethyldisilazane (HMDS) was applied to the surface. Then, photoresist 23 was applied to the surface to form a layer having a thickness between 1.0 and 1.3µm. Thereafter, the object was baked at 90°C (Step S2, FIG. 13B).

The wafer was then placed in an aligner and exposed it to light to produce a latent image of a pattern of a large number of contact holes (Step S3, FIG. 13C).

Subsequently, the wafer was placed in a reactive ion etching system and the exposed silicon oxide was anisotropically etched to produce a pattern of contact holes 24, using the developed photoresist pattern as mask (Step S4, FIG. 13D).

The specimen of wafer carrying a silicon oxide film and coated with a photoresist pattern was then dipped into a resist stripping solution, which was an aqueous solution containing KF by 1.9wt% and IPA by 54wt%, and ultrasonic waves of 0.95MHz were applied to the solution. Thus, the resist on the wafer was removed by dipping the specimen into the resist stripper for 5 minutes (Step S5, FIG. 13E). This step corresponds to a surface treatment step using a potassium-containing treatment agent.

The wafer now stripped of resist but carrying a silicon oxide film having contact holes was then successively subjected to five cleaning steps as shown in FIGS. 14A through 14E.

Firstly, the wafer stripped of resist was washed with ultrapure water containing ozone by 5ppm at room temperature to remove organic substances and metals adhering to it (Step SS1, FIG. 14A).

Subsequently, the wafer was washed with a cleaning aqueous solution containing HF by 0.5wt%, H₂O₂ by 0.1 to 1.0wt% and a trace of surfactant at room temperature, applying ultrasonic waves with a frequency of 0.95MHz, to remove natural oxide film, particles and metals on the surface (Step SS2, FIG. 14B).

Thereafter, the wafer was washed with ozone-containing ultrapure water at room temperature, applying ultrasonic waves of 0.95MHz (Step SS3, FIG. 14C).

Then, the wafer was washed with a 0.1wt% aqueous solution of dilute hydrofluoric acid (DHF) in order to further remove natural oxide film and effect termination of the surface of the silicon wafer (Step SS4, FIG. 14D).

Finally, the wafer was immersed in hot ultrapure water (HPW) at 80°C, applying ultrasonic waves of 0.95MHz, to cleanse the wafer (Step SS5, FIG. 14E).

Subsequently, the wafer was taken out of the thermostat tank and the extent of potassium adhesion was observed to find that it had been reduced to below the detectable limit. In other words, no significant adhesion of potassium to the silicon oxide film on the surface of the wafer was observed.

Alternatively, hot pure water may be used in Steps SS1 and SS2 or after Step SS5 in stead of using hot pure water in Step SS5.

As described above in detail by way of example, according to the invention, the extent of adhesion of an alkali metal such as potassium can be reduced by a simple cleaning method. A cleaning method according to the invention does not involve the use of a highly concentrated chemical solution containing hydrochloric acid, sulfuric acid or nitric acid. Thus, according to the invention, potassium can be removed with ease and hence a cleaning method according to the invention can be effectively applied to a process of treating the surface of an object such as a semiconductor device, an electrooptic device or an optical device with a potassium-containing solution to make the process feasible under various different conditions.

A treating method can effectively and efficiently remove alkali metals including potassium and significantly. It cleans an object brought into contact with a potassium-containing treatment agent by holding the object in contact with pure water heated to or above 80°C.

## Claims

1. A method of cleaning an object having a layer brought into contact with a potassium-containing treatment agent, characterized in that:
said layer of the object is held in contact with pure water heated to or above 80°C.

2. A cleaning method according to claim 1, wherein said object is an object polished by means of a potassium-containing solution.

3. A cleaning method according to claim 2, wherein said object has a layer on the surface, said layer being formed by a surface treatment method selected from a plasma processing method, a chemical vapor phase deposition method and/or a physical vapor phase deposition method.

4. A cleaning method according to claim 2, wherein said object has a layer on the surface, said layer being composed of a compound having a nonstoichiometric atomic ratio.

5. A cleaning method according to claim 1, wherein said object is an object cleansed by a potassium-containing solution to remove foreign objects on the surface.

6. A cleaning method according to claim 5, wherein said object has a layer on the surface, said layer being formed by a surface treatment method selected from a plasma processing method, a chemical vapor phase deposition method and/or a physical vapor phase deposition method.

7. A cleaning method according to claim 5, wherein said object has a layer on the surface, said layer being composed of a compound having a nonstoichiometric atomic ratio.

8. A cleaning method according to claim 1, wherein said potassium-containing treatment agent contains KOH, KF, KCl and/or K₂SO₄.

9. A cleaning method according to claim 1, wherein said potassium-containing treatment agent contains KOH, KF, KCl and/or K₂SO₄ and, additionally, an organic solvent and/or a water soluble salt.

10. A cleaning method according to claim 1, wherein said potassium-containing treatment agent contains KF and/or KCl by 0.005wt% to 10wt%.

11. A cleaning method according to claim 1, wherein ultrasonic waves between 0.8MHz and 10MHz are applied to said potassium-containing treatment agent.

12. A cleaning method according to claim 1, wherein said potassium-containing treatment agent additionally contains ozone.

13. A cleaning method according to claim 1, wherein said potassium-containing treatment agent additionally contains ozone and ultrasonic waves between 0.8MHz and 10MHz are applied to said potassium-containing treatment agent.

14. A cleaning method according to claim 1, wherein said object is at least a semiconductor device, an electrooptic device, an optical device or a ceramic object.

15. A cleaning method according to claim 1, wherein said layer is made of an oxide film.

16. A cleaning method according to claim 1, wherein said layer is made of a nonstoichiometric silicon oxide film.

17. A method of cleaning an object having a layer on the surface, said layer being formed by a surface treatment method selected from a plasma processing method, a chemical vapor phase deposition method and/or a physical vapor phase deposition method and brought into contact with a potassium-containing treatment agent, characterized in that
the object is held in contact with pure water heated to or above 80°C.

18. A method of cleaning an object having a layer on the surface, said layer being formed of a nonstoichiometric compound and brought into contact with a potassium-containing treatment agent, characterized in that:
the object is held in contact with pure water heated to or above 80°C.

19. A method of cleaning an object according to claim 1, comprising a first cleaning step of using ultrapure water containing ozone, a second cleaning step of conducting a cleaning operation by using a liquid containing hydrofluoric acid, hydrogen peroxide and a surface active agent and applying ultrasonic waves with a frequency above 100kHz, a third cleaning step of conducting a cleaning operation by using ultrapure water containing ozone and applying ultrasonic waves with a frequency above 100kHz, a fourth cleaning step of conducting a cleaning operation by using a liquid containing hydrofluoric acid and a fifth cleaning step of conducting a cleaning operation by using ultrapure water and applying ultrasonic waves with a frequency above 100kHz, characterized by:
further comprising a sixth cleaning step of bringing the object into contact with pure water heated to or above 80°C.

20. A cleaning method according to claim 19, wherein said sixth step is conducted simultaneously with at least one of said first, third and fifth steps by heating the ultrapure water to or above 80°C.

21. A cleaning method according to claim 19, wherein said sixth step is conducted before and/or after at least one of said first through fifth steps.

22. A method of cleaning an object according to claim 1, comprising a step of removing organic substances adhering to the object by using a liquid containing organic solvent and halogenated potassium and applying ultrasonic waves, characterized by:
further comprising a step of bringing the object into contact with pure water heated to or above 80°C after the removing step.

23. A method of cleaning an object according to claim 1, said object being polished by means of a potassium-containing treatment agent, characterized by:
comprising a step of bringing the object into contact with pure water heated to or above 80°C.

24. A cleaning method according to claim 23, wherein said object has a layer on the surface, said layer being made of silicon oxide formed by a chemical vapor phase deposition method or a physical vapor phase deposition method.

25. A method of treating the surface of an object having a layer on the surface, said layer being formed of a nonstoichiometric compound, characterized by comprising:
a first step of bringing the film of the object into contact with a potassium-containing treatment agent; and
a second step of reducing the amount of potassium adhering to the film by bringing the film of the object into contact with pure water heated to or above 80°C after the first step.

26. A treating method according to claim 25, wherein said film is formed by a surface treatment method selected from a plasma processing method, a chemical vapor phase deposition method and/or a physical vapor phase deposition method.

27. A treating method according to claim 25, wherein said first step is a polishing step using a potassium-containing treatment agent containing dispersed polishing particles.

28. A treating method according to claim 25, wherein said first step is a step of removing foreign objects on the surface of the film of the object.

29. A treating method according to claim 28, wherein said foreign objects are those of photoresist and/or photoresist residue.

30. A treating method according to claim 25, wherein said potassium-containing treatment agent is a liquid containing KOH, KF, KCl and/or K₂SO₄.

31. A treating method according to claim 25, wherein said second step is a step of dipping said object into the pure water contained in a container.

32. A treating method according to claim 25, wherein said second step is a step of feeding pure water from a nozzle onto the surface of the layer of the object.
